(19) Europäisches Patentamt
European Patent Office
Office européen des brevets

(11) **EP 2 863 234 A1**

(12) **EUROPEAN PATENT APPLICATION**

(43) Date of publication:
**22.04.2015 Bulletin 2015/17**

(51) Int Cl.:
***G01R 29/26*** (2006.01)

(21) Application number: **13290248.7**

(22) Date of filing: **17.10.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **NXP B.V.**
**5656 AG Eindhoven (NL)**

(72) Inventors:
• **David-Grignot, Stéphane**
  **Redhill Surrey RH1 1SH (GB)**

• **Latorre, Laurent**
  **Redhill Surrey RH1 1SH (GB)**
• **Azais, Florence**
  **Redhill Surrey RH1 1SH (GB)**
• **Lefevre, Francois**
  **Redhill Surrey RH1 1SH (GB)**

(74) Representative: **Cabinet Plasseraud**
**52, rue de la Victoire**
**75440 Paris Cedex 09 (FR)**

(54) **Method and apparatus for measuring phase noise**

(57)    An apparatus and method is provided for measuring the phase noise of an analogue ac signal. A 1-bit digitizer generates an oversampled 1 bit serial bit stream. This is analysed to identify crossing points in the original signal based on transitions in the 1 bit serial bit stream over a number of periods of the analogue ac signal. A first period or frequency is based on successive crossing points associated with a rising analogue ac signal and a second period or frequency is derived from successive crossing points associated with a falling analogue ac signal. A phase noise level can then be calculated. This provides a low cost and fast phase noise test.

FIG. 2

**Description**

The invention relates to testing of RF analogue circuit components, and relates in particular to the measurement of phase noise.

In the consumer electronics market, there is a continuous drive for reduced cost, while providing high levels of quality.

In order to improve margins, electronics companies are constantly looking for methods to decrease the production test costs. In the case of complex RF devices like silicon tuners, a lot of time-consuming RF tests should be performed to check the specification and functionality of the device. This leads to long test times and therefore high production costs. Also the possibility of testing several devices in parallel at the same time (so called multi-site) may be limited by the number of resources of the test equipment. The multi-site technique helps to reduce the test time per device under test but needs costly testers equipped with many resources. Moreover complex RF products require expensive RF & analogue-mixed-signal resources (source and measure units) to execute a test list compatible with customer quality needs.

One of the most important tests is checking the phase noise of the analogue/RF output signal. The specification parameter is linked to the product sensitivity, specifically at low reception levels.

This kind of measurement is traditionally done with expensive digitizers located in an industrial tester to capture the analogue signal, followed by signal analysis (such as using FFTs). The number of digitizers is usually limited because of the cost, so multi-site efficiency is reduced (all tested sites are not measured in parallel but serially, so increasing test time).

In summary, industrial phase noise testing needs expensive tester options (high test cost and capital expenditure) and long test time (due to limited multi-site efficiency).

The invention aims to reduce the cost of industrial phase noise test of analogue ac signals such as RF signals.

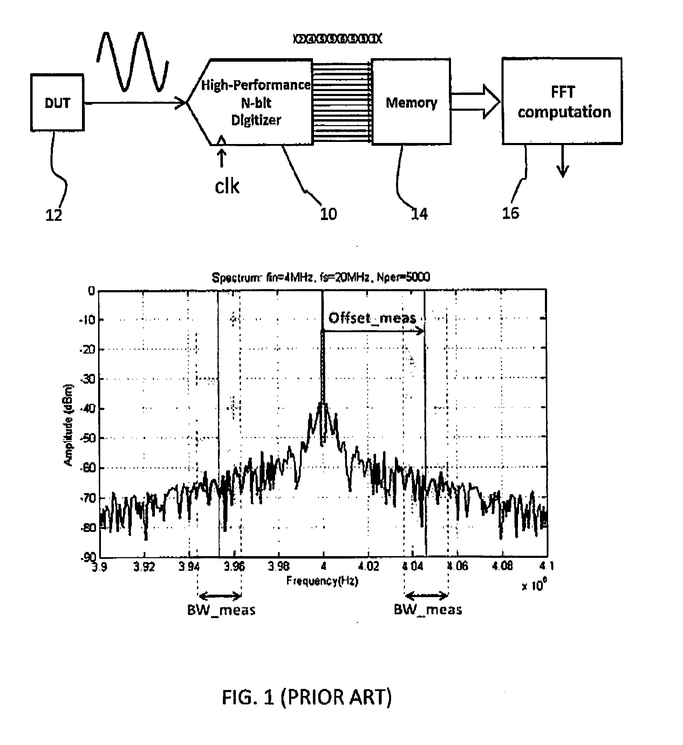

Figure 1 shows a conventional phase noise measurement. The tester digitizer 10 samples the analogue/RF signal to be tested from the device under test (DUT) 12, and the resulting N-bit digitized samples are stored in the tester memory 14. An FFT computation 16 is then performed on these digitized samples to get the spectrum of the analogue/RF signal. Finally, phase noise is computed by subtracting the carrier level from the noise level, where the noise level is measured by integrating the noise over a specific bandwidth ("BW_meas") on both sides of the carrier at a specified distance of the carrier ("offset_meas"). The graph in Figure 1 shows the FFT spectrum and shows the parameters used to derive the noise level.

As outlined above, the main problem with this approach is the high cost digitizer resource 10.

The invention is defined by the claims.

According to the invention, there is provided an apparatus for measuring the phase noise of an analogue ac signal, comprising:

a 1-bit digitizer for digitizing the analogue ac signal with a sampling frequency above the frequency of the analogue ac signal and which generates a sampled signal comprising 1 bit serial bit stream; and
a processor for analysing the 1 bit serial bit stream,
wherein the processor is adapted to:

identify crossing points of the analogue ac signal based on transitions in the 1 bit serial bit stream over a number of periods of the analogue ac signal;
derive a first period or frequency from successive crossing points associated with a rising analogue ac signal;
derive a second period or frequency from successive crossing points associated with a falling analogue ac signal; and
calculate a phase noise level from the first period or frequency, the second period or frequency and the number of periods.

The invention replaces the high-performance N-bit digitizer capture performed by the conventional industrial tester by a 1-bit capture of the analogue signal. A dedicated post-processing algorithm is then used to compute the analogue signal phase noise characteristic from the properties of the captured serial bit stream, in particular the period or frequency information derived from the crossing points as identified by transitions in the serial bit stream.

The invention enables the development of low-cost methods to test analogue (and in particular RF) devices. More specifically, the solutions for performing phase noise measurements on analogue/RF signals are enabled using cheap hardware resources. An oversampling 1-bit digitizer is used in order to convert the analogue signal into a serial digital bit stream. The analogue signal phase noise characteristic is obtained from the serial bit stream properties, so that low-cost test becomes possible.

This enables improved parallelism of the test, since by avoiding the need for an expensive multi-bit digitizer located in an industrial tester, the test cost is reduced. By using resources embedded in a product, or cheap digital channels, all devices under test can be tested at the same time, thus reducing the test time, leading to more test cost reduction.

In one example, the crossing points are the crossing points of a threshold level, below which a 0 is returned by the digitization and above which a 1 is returned by the digitization. Typically, the threshold is the zero value. A rising crossing point is where there is a transition from 0 to 1 in the digital signal and a falling crossing point is where there is a transition from 1 to 0. Of course, whether a bit is named 1 or 0 is arbitrary so that the opposite relationship between the ac signal and the serial bit stream can be established.

The processor can be adapted to calculate the phase noise as:

$$\widehat{\sigma}_{fnoise} = \sqrt{\frac{\pi}{2}} \, MAD(freq\_est)$$

in which:

$$MAD(freq\_est) =$$

$$\frac{\sum_{i=1}^{Nper} |freq\_est\_from\_rise(i) - f| + \sum_{i=1}^{Nper} |freq\_est\_from\_fall(i) - f|}{2Nper}$$

wherein Nper is the number of periods, freq_est_from_rise is the first frequency, freq_est_from_fall is the second frequency, and f is the frequency of the analogue ac signal.

This function combines the estimated frequency from each successive rising crossing point and each successive falling crossing point within the set of samples, to provide a phase noise estimation. It is based on mean average deviation of the measured frequency from the expected frequency.

The sampling frequency is preferably an integer multiple of the analogue ac signal frequency. It has been found that this enables lower noise levels to be accurately determined.

The number of periods can be less than 100,000. For an RF signal, this implies a short test time, and shorter than with a conventional testing apparatus.

The 1 bit digitizer can be part of a testing apparatus (which can be lower cost than the known apparatus) or else the testing can be integrated into the apparatus which generates the ac signal to be tested.

The invention also provides a method of measuring the phase noise of an analogue ac signal, comprising:

generating a sampled digitised signal from the analogue ac signal, comprising a 1 bit serial bit stream with a sampling frequency above the frequency of the analogue ac signal;
identifying crossing points of the analogue ac signal based on transitions in the 1 bit serial bit stream over a number of periods of the analogue ac signal;
deriving a first period or frequency from successive crossing points associated with a rising analogue ac signal;
deriving a second period or frequency from successive crossing points associated with a falling analogue ac signal;
calculating a phase noise level from the first period or frequency, the second period or frequency and the number of periods.

This is the method carried out by the apparatus of the invention.

The method can further comprise selecting a number of samples to process based on the analogue ac signal frequency, an expected phase noise level to be evaluated and a target phase noise estimation accuracy. This approach enables the test to be tailored to the desired results, so that the testing time can be kept to a minimum to achieve desired test results.

Similarly, the sampling frequency can be selected based on the analogue ac signal frequency, an expected phase noise level to be evaluated and a target phase noise estimation accuracy.

In this way, appropriate acquisition parameters (sampling frequency and number of captured signal periods) can be chosen to guarantee a given estimation error, and these can be determined based on an analytical standard error model.

The invention also provides a computer program for implementing the method of the invention.

Examples of the invention will now be described in detail with reference to the accompanying drawings, in which:

Figure 1 shows a known phase noise testing arrangement;
Figure 2 shows a phase noise testing arrangement of the invention;
Figure 3 is used to show the signal properties used in the processing of the invention;
Figure 4 shows the accuracy of the phase noise estimation for known injected phase noise, and shows how the estimate is dependent on the sampling frequency;
Figure 5 shows the error in the phase noise estimation for different sampling frequencies;
Figure 6 shows the error in the phase noise estimation for different number of processed samples;
Figure 7 shows error levels for different sampling frequencies and sample sizes, and is used to show how an error model can be used to select the appropriate parameters for a particular phase noise measurement; and
Figure 8 shows the selection of two sample sizes for different phase noise measurement examples.

The invention provides an apparatus and method for measuring the phase noise of an analogue ac signal. A 1-bit digitizer generates an oversampled 1 bit serial bit stream. This is analysed to identify crossing points in the original signal based on transitions in the 1 bit serial bit stream over a number of periods of the analogue ac signal. A first period or frequency is based on successive crossing points associated with a rising analogue ac signal and a second period or frequency is derived from successive crossing points associated with a falling analogue ac signal. A phase noise level can then be calculated. This provides a low cost and fast phase noise test.

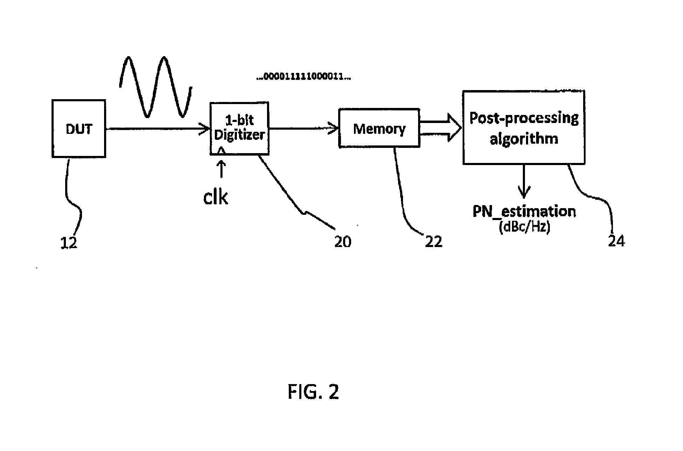

Figure 2 shows a phase noise test circuit of the invention.

The invention replaces the high-performance N-bit digitizer capture performed by the conventional industrial tester by a 1-bit capture of the analogue signal, using a 1-bit digitizer 20. The bit stream is stored in memory 22, and dedicated post-processing algorithm 24 is then used to compute the analogue signal phase noise characteristic from the properties of the captured serial bit stream. Thus, unit 24 represents a processor, which may be implemented as a combination of hardware and software (as discussed below).

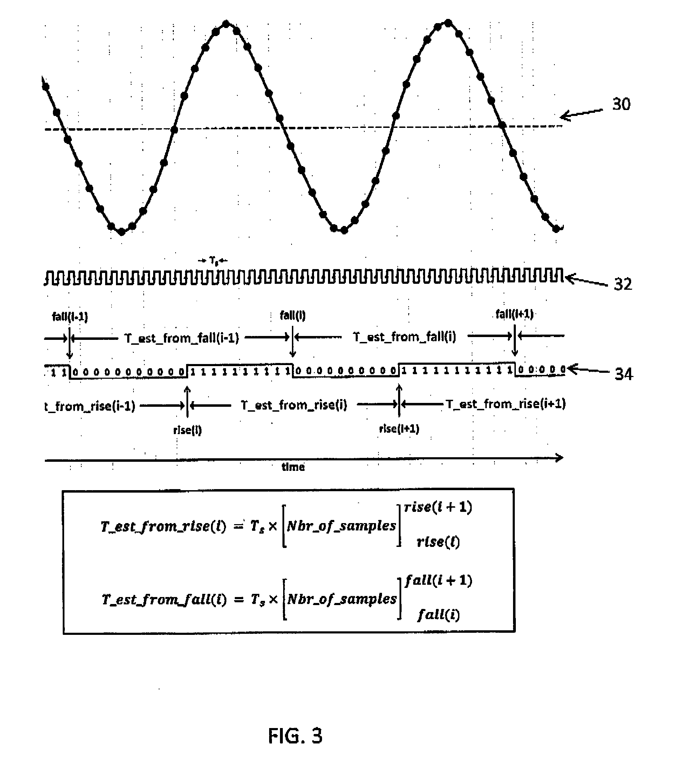

Figure 3 shows the analogue signal 30 to be tested, and the 1-bit sampling instants are shows as the dots, at a higher sampling frequency corresponding to a sampling clock (plot 32).

The sequence of "0" and "1" of the serial bit stream 34 is processed to determine rising and falling transitions (shown as fall(i-1), rise(i), fall(i), rise(i+1) and fall(i+1)).

The number of samples captured between two successive rising transitions and between two successive falling transitions is recorded. Each of these represents an estimate of the signal period.

At each signal period, two estimations of the signal frequency are then computed with:

$$freq\_est\_from\_rise(i) = \frac{f_s}{\left[ Nbr\_of\_samples \right]_{rise(i)}^{rise(i+1)}}$$

$$freq\_est\_from\_fall(i) = \frac{f_s}{\left[ Nbr\_of\_samples \right]_{fall(i)}^{fall(i+1)}}$$

Figure 3 shows the same equations but showing the corresponding estimate of signal period T.

For example, in the first equation above, the denominator represents the number of samples from time rise(i) to time rise(i+1).

In the case of no phase noise, the estimated frequency remains constant whatever the signal period, but in the presence of phase noise the estimated frequency varies over time. Statistics of this variation are exploited to compute the signal phase noise.

The invention enables not only the phase noise of an analogue/RF signal to be estimated, but also enables selection of the appropriate acquisition parameters (sampling frequency and number of captured signal periods) to estimate a specific phase noise target value with given accuracy.

In order to achieve this, a phase noise model that allows phase noise to be injected into a time-domain sine-wave signal has been created. This model relies on the integration of a noisy frequency generated using a random variable with normal distribution:

$$\varepsilon = randn(Nsamples,1)$$

Nsamples is the number of samples collected over Nper periods at a sampling ration of $f_s/f$:

$$Nsamples = Nper * (f_s/f).$$

The frequency noise is given by:

$$f_{noise} = \sqrt{\frac{f_s}{f}} * \sigma_{fnoise} \times \varepsilon$$

The square root term is a standardising factor for the same $\sigma_{fnoise}$ on each period whatever the value of $f_s$.

The phase noise is given by:

$$\Phi(nT_s) = 2\pi T_s * \sum_{i=1}^{n} fnoise$$

The signal with the phase noise and initial random phase is given by:

$$Signal(nT_s) = \sin(2\pi f nT_s + \Phi(nT_s) + \Phi_{init})$$

These equations assume the signal has a known and constant frequency f to which the phase noise has been added. This frequency can be known and with sufficient accuracy from the system specification, or it may be known but with a limited accuracy (i.e. located in a range). In this case, the method can include first measuring the frequency, then adjusting the acquisition parameters before performing a second acquisition for the phase noise test itself.

In particular, the signal frequency can be accurately calculated as the mean value of the frequency estimations computed from the serial bit stream, as expressed by the following equation:

$$\hat{f} = \frac{\sum_{i=1}^{Nper}(freq\_est\_from\_rise(i) + freq\_est\_from\_fall(i))}{2Nper}$$

The model explained above allows the phase noise level injected in the time-domain signal to be controlled by adjusting the value of $\sigma_{fnoise}$. Moreover, an analytical expression has been established that links the phase noise level injected in the time-domain signal (expressed in Hz) to the phase noise level measured on the signal spectrum with the conventional test method (expressed in dBc/Hz):

$$PN@Offset\_meas_{dBc/Hz} =$$

$$20log_{10}\left(\sigma_{fnoise}\right) - 20log_{10}\left(\frac{\pi}{2}\sqrt{f} * Offset\_meas\right)$$

From a comprehensive simulation study performed under various signal conditions (different values of signal frequency $f$ and different values of phase noise level $\sigma_{fnoise}$) and various acquisition conditions (different values of the sampling frequency $f_s$ and different values of the number of captured signal periods $Nper$), an estimator of the phase noise level included in the time-domain sine-wave signal is proposed:

$$\widehat{\sigma}_{fnoise} = \sqrt{\frac{\pi}{2}}\ MAD(freq\_est)$$

where $MAD(freq\_est)$ is the Mean Average Deviation of the estimated frequency computed with:

$$MAD(freq\_est) =$$

$$\frac{\sum_{i=1}^{Nper}|freq\_est\_from\_rise(i) - f| + \sum_{i=1}^{Nper}|freq\_est\_from\_fall(i) - f|}{2Nper}$$

This function sums the deviation of the derived frequency from the expected frequency for the rising edge and falling edge frequency calculations and finds an average value. This mean average deviation value is the preferred indicator of the phase noise. However, other indicators can be used.

For example, the standard deviation of the frequency estimations can be used as an estimator of the phase noise level (standard deviation is the most commonly-used measure of statistical dispersion):

$$\widehat{\sigma}_{fnoise} = \sigma(freq\_est)$$

where $\sigma(freq\_est)$ is computed with:

$$\sigma(freq\_est) =$$

$$\sqrt{\frac{\sum_{i=1}^{Nper}(freq\_est\_from\_rise(i) - f)^2 + \sum_{i=1}^{Nper}(freq\_est\_from\_fall(i) - f)^2}{2Nper - 1}}$$

Experiments performed with various values of the noise level and various values of the sampling frequency show that this estimator yields a correct evaluation of phase noise level present in the analogue signal for higher levels of noise (for example higher than 0.1 %), and provided that the sampling frequency is high enough (higher than 500 times the signal frequency).

The use of the mean average deviation value is preferred as the correct evaluation of the phase noise level present in the analogue signal is achieved even for low levels of noise (below 0.1%), provided that the sampling frequency is an integer number of the signal frequency, but without constraint of the value of the sampling ratio.

This result derives from the fact that the sampling process used for signal acquisition introduces a quantization of the frequency estimation. As a result, the distribution of the frequency estimations is a discrete distribution. In the case of low level of phase noise, there are not enough bins to have a correct evaluation of the noise level using an estimator based on standard deviation while the estimator based on the MAD function is not sensitive to this aspect.

Thus, for high noise levels, both estimators lead to correct evaluation. However the estimator based on the MAD function is more robust, in particular regarding low noise levels and limited sampling frequency ratios. This is of course of particular importance with respect to many practical applications, in particular if the objective is to evaluate signals affected with low phase noise (typically with a noise level lower than 0.1 %), and using cheap resources (so with limited operating frequency capabilities).

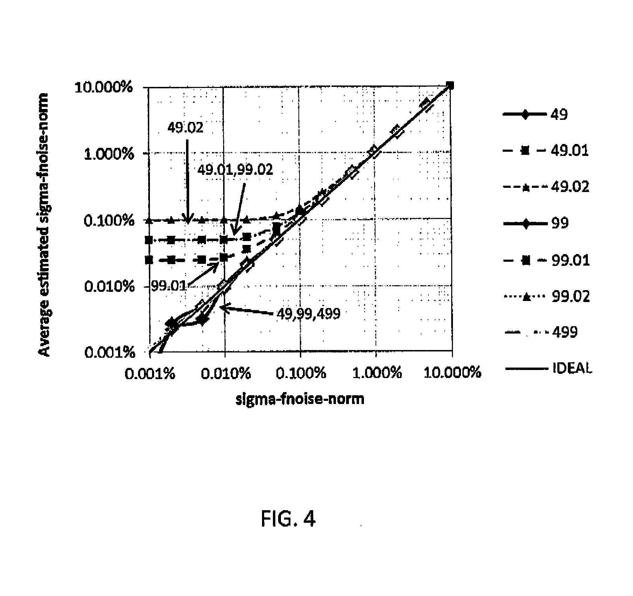

Figure 4 shows a study of this phase noise estimator for a given number of captured signal periods $Nper = 1000$.

The x-axis shows the injected phase noise normalised with respect to frequency. The different plots show different sampling ratios $f_s/f$.

The plots which level out for lower injected noise values (and therefore are less accurate for low injected noise levels) are those with non-integer sampling ratios, whereas those with integer ratios follow the ideal (straight line) plot closely even for low levels of injected noise.

Figure 4 shows that there is a good correlation between the phase noise level injected in the analogue sine-wave signal and the average phase noise level estimated from the analysis of the serial bit stream, provided that the sampling frequency $f_s$ is an integer multiple of the signal frequency $f$.

In case the sampling frequency is not an exact multiple of the signal frequency (hence plots for 49.01, 49.02, 99.01 and 99.02), the validity domain of the proposed estimator is limited to phase noise levels higher than 0.1 %.

In summary, when the 1-bit digitization of the analogue/RF signal under test is realized with a sampling frequency $f_s$ which is an integer multiple of the signal frequency $f$, evaluation of the phase noise level present in the time-domain sine-wave signal is possible using the proposed estimator, even for low phase noise level (below 0.1 %) and relatively low sampling ratio (below 100). Without an integer multiple it is possible to evaluate larger phase noise levels.

An estimation of the phase noise value expressed in dBc/Hz corresponding to the phase noise level measured on the signal spectrum at a given frequency offset of the signal frequency can be accomplished with:

$$\widehat{PN@Offset\_meas}_{dBc/Hz} = 20 log_{10} \left( \frac{\widehat{\sigma}_{fnoise}}{\frac{\pi}{2}\sqrt{f * Offset\_meas}} \right)$$

$$\widehat{PN@Offset\_meas}_{dBc/Hz} = 20 log_{10} \left( \frac{MAD(freq\_est)}{\sqrt{\frac{\pi}{2}f * Offset\_meas}} \right)$$

The performance of the method of the invention can be evaluated in terms of estimation error.

The error is defined as the difference between the phase noise value estimated from the analysis of the serial bit stream and the phase noise value computed from the signal spectrum:

$$\varepsilon_{dBc/Hz} = \widehat{PN} - PN = 20 \, log_{10} \left( \frac{\widehat{\sigma}_{fnoise}}{\sigma_{fnoise}} \right)$$

The influence of the acquisition parameters (sampling ratio $f_s/f$ and number of captured signal periods $Nper$)

on the estimation error have been identified through extensive simulations with multiple random runs performed for each different value of the phase noise level. These simulations show that the average estimation error is very low whatever the acquisition conditions, but that the estimation error exhibits a dispersion which depends on both the sampling ratio $f_s/f$ and the number of captured signal periods $Nper$:

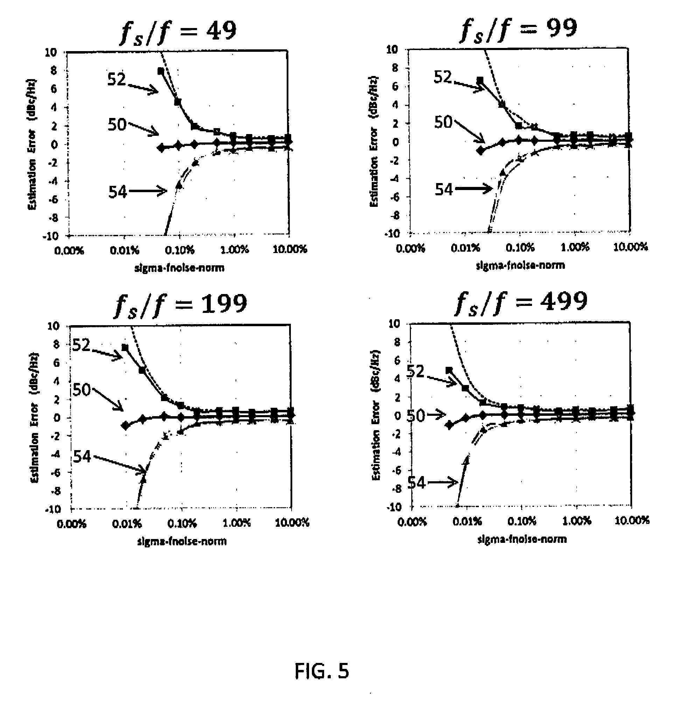

The results shown in Figure 5 illustrate that the higher the sampling ratio, the lower the phase noise level that can be evaluated with a low estimation error ($\cong 0.5$dBc/Hz).

The four plots of Figure 5 show the estimation error ($\varepsilon_{dBc/Hz}$) as defined above versus the noise level $\sigma_{fnoise\_norm}$ for four different sampling ratios $f_s/f$.

100 random runs were carried out with Nper=1000. The plots all show results for a set of different noise levels. The average error for the set is shown (plot 50), the maximum error (plot 52), the minimum error (plot 54), as well as curves showing 3 significant figures above and below the mean.

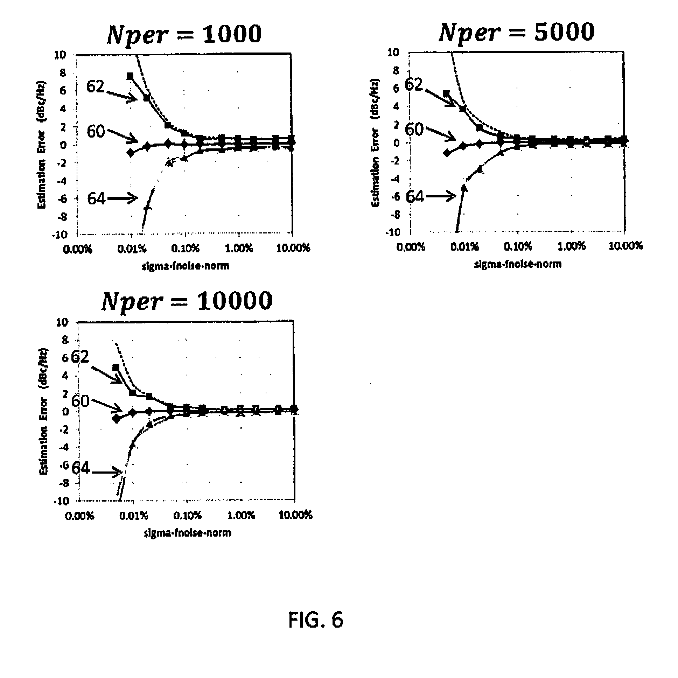

The results shown in Figure 6 show that the longer the acquisition length, the lower the dispersion on the estimation error.

The three plots of Figure 6 show the estimation error ($\varepsilon_{dBc/Hz}$) as defined above versus the noise level $\sigma_{fnoise\_norm}$ for three different acquisition lengths Nper.

100 random runs were again carried out with $f_s/f$=199. The plots all show results for a set of different noise levels. The average error for the set is shown (plot 60), the maximum error (plot 62), the minimum error (plot 64), as well as curves showing 3 significant figures above and below the mean.

An analytical model for the standard error of the phase noise estimation can also be defined:

$$\widehat{SE}(\widehat{PN}) = max\left\{\frac{20}{ln(10)\sqrt{2Nper}}, \frac{20\gamma}{ln(10)\sqrt{2Nper}} \cdot \frac{f^2}{f_s} \cdot \frac{1}{\sigma_{fnoise}}\right\}$$

with

$$\gamma = 0.40 \quad if \quad n = f_s/f \quad odd$$

$$\gamma = 0.74 \quad if \quad n = f_s/f \quad even$$

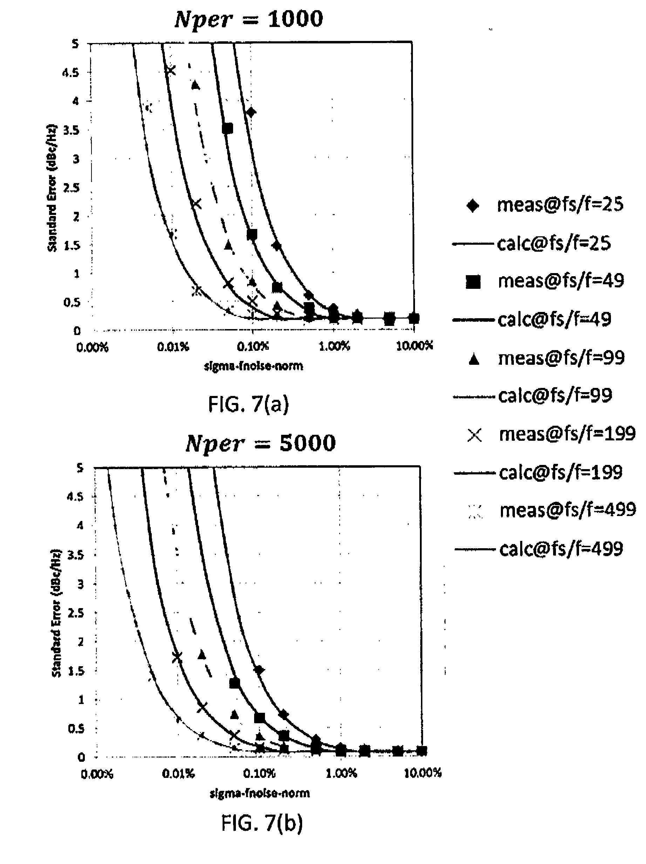

The standard error computed with this model exhibits a very good agreement with the standard error evaluated from extensive simulations with multiple random runs, as shown in Figures 7(a) to (c).

The figures show the error as measured and as calculated at different sampling frequencies $f_s/f$. The indicated points show the measured values, and the solid lines show the corresponding function calculations. In all cases, the calculated functions essentially pass through the measured points.

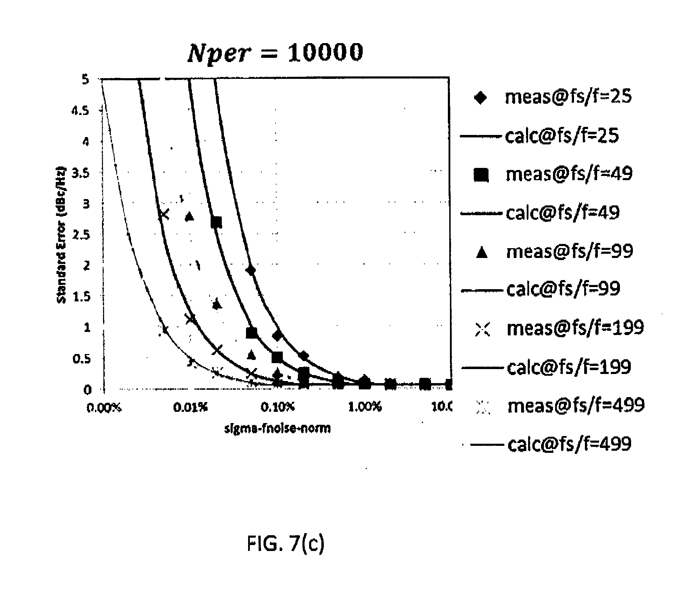

Figure 7(a) shows calculations for Nper=1000, Figure 7(b) shows calculations for Nper=5000 and Figure 7(c) shows calculations for Nper=10000.

This standard error model means it is possible to choose the best test set-up to achieve a specific phase noise measurement with a specific accuracy.

In particular, considering a given signal frequency $f$, a given phase noise level $\sigma_{fnoise}|_{typ}$ to be evaluated and a given targeted estimation uncertainty $\Delta PN$, the targeted standard error can be defined with:

$$SE(\widehat{PN})|_{target} = \frac{|\Delta PN|}{n} \quad for \quad erf(n/\sqrt{2}) \quad confidence \quad level$$

The relation between $n$ and the confidence level expressed in % is given in the table below.

| nσ | Confidence level |
|---|---|
| 1σ | 68.2689492137% |
| 2σ | 95.4499736104% |
| 3σ | 99.7300203937% |
| 4σ | 99.9936657516% |
| 5σ | 99.9999426697% |
| 6σ | 99.9999998027% |

Using the analytical expression of the standard error, the minimum number of signal periods to capture in order to satisfy the targeted estimation uncertainty for a given sampling ratio is expressed by:

$$Nper|_{min} = \left( \frac{20\gamma}{ln(10)\sqrt{2}} \cdot \frac{f^2}{f_s} \cdot \frac{1}{\sigma_{fnoise}|_{typ}} \cdot \frac{n}{|\Delta PN|} \right)^2$$

In the same way, the minimum sampling ratio to be used in order to satisfy the targeted estimation uncertainty for a given number of captured signal periods is expressed by:

$$\frac{f_s}{f}\bigg|_{min} = \frac{20\gamma}{ln(10)\sqrt{2Nper}} \cdot \frac{f}{\sigma_{fnoise}|_{typ}} \cdot \frac{n}{|\Delta PN|}$$

Below is an example for a silicon tuner measurement.

The example is shown to provide a real case and to illustrate the advantages of the method but should not be seen as a limitation of the invention.

The object is to measure the phase noise present on the IF output, which is a 4MHz sine-wave signal. Using the conventional test method, the typical phase noise value measured at an offset frequency $Offset\_meas$=100kHz on the signal spectrum is $PN@100kHz|_{typ}$ = -109dBc/Hz. The classical uncertainty for such a measurement is $\Delta PN$=±2dBc/Hz.

Using the proposed test method, the typical phase noise level $\sigma_{fnoise|typ}$ to be evaluated is:

$$\sigma_{fnoise}|_{typ} = \frac{\pi}{2}\sqrt{f} * Offset_{meas} * 10^{\frac{PN@Offset_{meas}}{20}} = 1.115kHz$$

The targeted estimation uncertainty is set at the same value than with the conventional test method, i.e. $\Delta PN$=±2dBc/Hz.

From the standard error model, the minimum number of signal periods to capture in order to satisfy this uncertainty is:

$$Nper|_{min} = \left( 1.763 \times 10^{10} \times \frac{n}{f_s} \right)^2 \quad \text{for } f_s/f \text{ odd}$$

Two practical cases are considered, corresponding to a maximum sampling frequency of either 200MHz or 400MHz.

In the first case, appropriate acquisition parameters to satisfy the targeted estimation uncertainty are $f_s$=196MHz

and *Nper*=72791, which leads to an acquisition time of 18.2ms.

In the second case, appropriate acquisition parameters to satisfy the targeted estimation uncertainty are $f_s$=396MHz and *Nper*=17832, which leads to an acquisition time of 4.5ms.

In both cases, the considered values of the sampling frequency are realistic and the test time is much smaller than when using traditional methods.

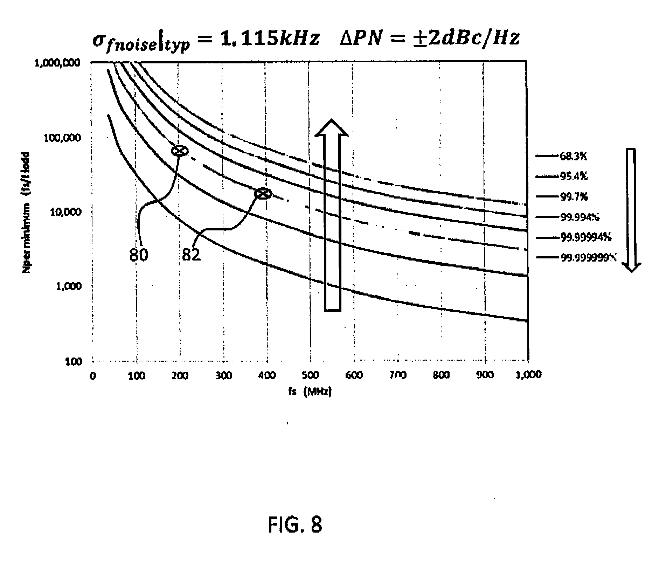

The results are shown in Figure 8.

The different plots relate to different estimation certainties, ranging from 99.999999% down to 68.3%. Of course, the greater certainty requires a larger value of Nper, as shown by the arrows.

■ <u>Case 1</u>: $f_s|_{max}$= 200MHz

$$\left.\frac{f_s}{f}\right|_{max} = 50 \text{ and } \frac{f_s}{f} \text{ odd} \Rightarrow f_s = 196 \text{MHz}$$

- 99.7% confidence level (3σ) $\Rightarrow Nper|_{min}$=72791 ⮑ **$f_s$= 196 MHz & *Nper* = 72791 => 18.2ms acquisition time**

■ Case <u>2</u>: $f_s|_{max}$= 400 MHz

$$\left.\frac{f_s}{f}\right|_{max} = 100 \text{ and } \frac{f_s}{f} \text{ odd} \Rightarrow f_s = 396 \text{ MHz}$$

- 99.7% confidence level (3σ) $\Rightarrow Nper|_{min}$=17832

⮑ **$f_s$= 396 MHz & *Nper* = 17832 => 4.5ms acquisition time**

Case 1 corresponds to point 80, and case 2 corresponds to point 82.

The method described above enables industrial test cost reduction for phase noise tests as a result of shorter test time, better multi-site efficiency and above all lower cost measurement resources. The idea includes a way to calculate optimized requirements for the test set-up in order to achieve the needed test specifications.

There are various ways to implement the circuitry for carrying out the approach described above. Two non-limiting approaches are described below.

A first implementation uses a digital channel of an industrial tester to perform the oversampling 1-bit conversion. Such digital channels are widely available on such equipment and cost nothing compared to the expensive digitizer required for traditional phase noise measurement.

In such an implementation, the output signal to be measured of the device under test is connected to the digital channel of the industrial tester. The sampling frequency of the digital channel and the acquisition time should be set according to the method explained above. The calculations are then performed inside the tester to compute the estimated phase noise according to the approach explained above.

In a second implementation, the oversampling 1 bit conversion is carried out internally in the device under test, for instance by adding a comparator and a clocked latch in the device. If the analogue signal to be measured is not available outside due to electrical sensitivity for instance, this second implementation can be used.

The resulting sampled digital signal may be directly sent to a digital tester for further processing using software-based computation. Alternatively, the sampled digital signal may be stored internally in a memory. It can then be output to the tester at lower speed for further processing, or processed in the device with a DSP for instance.

There are other ways of implementing the approach without departing from the underlying concept, and these alternative approaches will be apparent to those skilled of the art of design or testing. The invention can be integrated in a device to be tested or as part of an industrial tester.

The invention enables production phase noise testing of RF and analogue products to be realized on simple low cost industrial testers. Moreover as limited tester resources are required, more devices may be tested in parallel (increasing multi-site testing), thus providing even further test cost reduction. Also simple testers are less expensive when bought.

The invention is applicable to any circuit for which phase noise testing is desired. Silicon tuners are only one example of such circuits. For example, one possible application is for phase noise calibration, to optimize product behaviour. Because the invention allows embedded phase noise measurement, a device is able to perform its own phase noise measurement. Then depending on the value of the phase noise as measured by the product itself, it is possible to tune some parameters to optimize the device behaviour. A possible application is device internal current optimisation in order to reduce as much as possible the product power consumption.

Also when several VCOs (voltage controlled oscillators) or PLLs (phase locked loops) are implemented in a product, it should be possible to select one depending on its phase noise performance.

The invention makes use of a processor to implement the desired calculations. The processor can be implemented in numerous ways, with software and/or hardware, to perform the various functions required. The processor can be microprocessor arrangement, which employs one or more microprocessors that may be programmed using software (e.g., microcode) to perform the required functions. A processor may however be implemented with or without employing a microprocessor, and also may be implemented as a combination of dedicated hardware to perform some functions and a processor (e.g., one or more programmed microprocessors and associated circuitry) to perform other functions.

Examples of processor components that may be employed in various embodiments of the present disclosure include, but are not limited to, conventional microprocessors, application specific integrated circuits (ASICs), and field-programmable gate arrays (FPGAs).

In various implementations, a processor or controller may be associated with one or more storage media such as volatile and non-volatile computer memory such as RAM, PROM, EPROM, and EEPROM. The storage media may be encoded with one or more programs that, when executed on one or more processors and/or controllers, perform at the required functions. Various storage media may be fixed within a processor or controller or may be transportable, such that the one or more programs stored thereon can be loaded into a processor or controller.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage.

A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

**Claims**

1. An apparatus for measuring the phase noise of an analogue ac signal, comprising:

   a 1-bit digitizer (20) for digitizing the analogue ac signal with a sampling frequency above the frequency of the analogue ac signal and which generates a sampled signal comprising 1 bit serial bit stream; and
   a processor (24) for analysing the 1 bit serial bit stream,
   wherein the processor is adapted to:

   identify crossing points of the analogue ac signal (30) based on transitions in the 1 bit serial bit stream (34) over a number of periods of the analogue ac signal;
   derive a first period or frequency from successive crossing points associated with a rising analogue ac signal;
   derive a second period or frequency from successive crossing points associated with a falling analogue ac signal; and
   calculate a phase noise level from the first period or frequency, the second period or frequency and the number of periods.

2. An apparatus as claimed in claim 1, wherein the processor (24) is adapted to calculate the phase noise as:

$$\widehat{\sigma}_{fnoise} = \sqrt{\frac{\pi}{2}}\ MAD(freq\_est)$$

in which:

$$MAD(freq\_est) =$$

$$\frac{\sum_{i=1}^{Nper}|freq\_est\_from\_rise(i) - f| + \sum_{i=1}^{Nper}|freq\_est\_from\_fall(i) - f|}{2Nper}$$

wherein Nper is the number of periods, freq_est_from_rise is the first frequency, freq_est_from_fall is the second frequency, and f is the frequency of the analogue ac signal.

3. An apparatus as claimed in claim 1 or 2, wherein the sampling frequency is an integer multiple of the analogue ac signal frequency.

4. An apparatus as claimed in any preceding claim, wherein the number of periods is less than 100,000.

5. An apparatus as claimed in any preceding claim, wherein the 1 bit digitizer (20) is part of a testing apparatus.

6. An apparatus comprising a circuit for generating an analogue ac signal, and apparatus as claimed in any one of claims 1 to 4 for measuring the phase noise of the analogue ac signal.

7. A method of measuring the phase noise of an analogue ac signal, comprising:

   generating a sampled digitised signal (34) from the analogue ac signal, comprising a 1 bit serial bit stream with a sampling frequency above the frequency of the analogue ac signal;
   identifying crossing points of the analogue ac signal (30) based on transitions in the 1 bit serial bit stream over a number of periods of the analogue ac signal;
   deriving a first period or frequency from successive crossing points associated with a rising analogue ac signal;
   deriving a second period or frequency from successive crossing points associated with a falling analogue ac signal;
   calculating a phase noise level from the first period or frequency, the second period or frequency and the number of periods.

8. A method as claimed in claim 7, comprising calculating the phase noise as:

$$\widehat{\sigma}_{fnoise} = \sqrt{\frac{\pi}{2}}\, MAD(freq\_est)$$

in which:

$$MAD(freq\_est) =$$

$$\frac{\sum_{i=1}^{Nper}|freq\_est\_from\_rise(i) - f| + \sum_{i=1}^{Nper}|freq\_est\_from\_fall(i) - f|}{2Nper}$$

wherein Nper is the number of periods, freq_est_from_rise is the first frequency, freq_est_from_fall is the second frequency, and f is the frequency of the analogue ac signal.

9. A method as claimed in claim 8, wherein the sampling frequency is an integer multiple of the analogue ac signal frequency.

10. A method as claimed in claim 8 or 9, wherein the number of periods is less than 100,000.

11. A method as claimed in any one of claims 8 to 10, further comprising selecting a number of samples to process based on the analogue ac signal frequency, an expected phase noise level to be evaluated and a target phase noise estimation accuracy.

12. A method as claimed in any one of claims 8 to 11, further comprising selecting sampling frequency based on the analogue ac signal frequency, an expected phase noise level to be evaluated and a target phase noise estimation accuracy.

13. A method as claimed in any one of claims 8 to 12, wherein the method is carried in a testing apparatus, or in an apparatus which generates the analogue ac signal.

14. A computer program comprising computer program code means adapted to perform all of the steps of any one of claims 8 to 13 when said program is run on a computer.

15. A computer program as claimed in claim 14 embodied on a computer readable medium.

FIG. 1 (PRIOR ART)

...000011111000011...

DUT

1-bit
Digitizer

clk

Memory

Post-processing
algorithm

PN_estimation
(dBc/Hz)

12

20

22

24

FIG. 2

$$T\_est\_from\_rise(i) = T_s \times \left[Nbr\_of\_samples\right]_{rise(i)}^{rise(i+1)}$$

$$T\_est\_from\_fall(i) = T_s \times \left[Nbr\_of\_samples\right]_{fall(i)}^{fall(i+1)}$$

FIG. 3

FIG. 4

FIG. 5

FIG. 6

$Nper = 1000$

FIG. 7(a)

- ◆ meas@fs/f=25
- —— calc@fs/f=25
- ■ meas@fs/f=49
- —— calc@fs/f=49
- ▲ meas@fs/f=99
- —— calc@fs/f=99
- ✕ meas@fs/f=199
- —— calc@fs/f=199
- ⠿ meas@fs/f=499
- —— calc@fs/f=499

$Nper = 5000$

FIG. 7(b)

FIG. 7(c)

$$\sigma_{fnoise}|_{typ} = 1.115kHz \quad \Delta PN = \pm 2dBc/Hz$$

FIG. 8

Europäisches
Patentamt

European
Patent Office

Office européen
des brevets

## EUROPEAN SEARCH REPORT

Application Number

EP 13 29 0248

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2009/281751 A1 (ISHIDA MASAHIRO [JP] ET AL) 12 November 2009 (2009-11-12) * abstract * * paragraphs [0040], [0068]; figures 1,12 * ----- | 1-15 | INV. G01R29/26 |
| A | WO 2011/047698 A1 (VERIGY PTE LTD SINGAPORE [SG]; PAUSINI MARCO [DE]; RIVOIR JOCHEN [DE]) 28 April 2011 (2011-04-28) * abstract; figure 7 * ----- | 1-15 | |

TECHNICAL FIELDS
SEARCHED (IPC)

G01R

The present search report has been drawn up for all claims

| Place of search | Date of completion of the search | Examiner |
|---|---|---|
| Berlin | 11 April 2014 | Binger, Bernard |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 13 29 0248

This annex lists the patent family members relating to the patent documents cited in the above-mentioned European search report.
The members are as contained in the European Patent Office EDP file on
The European Patent Office is in no way liable for these particulars which are merely given for the purpose of information.

11-04-2014

| Patent document cited in search report | | Publication date | Patent family member(s) | | Publication date |
|---|---|---|---|---|---|
| US 2009281751 | A1 | 12-11-2009 | JP 2009271078 A | | 19-11-2009 |
| | | | US 2009281751 A1 | | 12-11-2009 |
| WO 2011047698 | A1 | 28-04-2011 | TW 201125321 A | | 16-07-2011 |
| | | | US 2012256639 A1 | | 11-10-2012 |
| | | | WO 2011047698 A1 | | 28-04-2011 |

EPO FORM P0459

For more details about this annex : see Official Journal of the European Patent Office, No. 12/82